# EUROPEAN PATENT SPECIFICATION

(11) **EP 4 624 941 B1**
(45) Date of publication and mention of the grant of the patent: **18.02.2026**
(21) Application number: 24167579.2
(22) Date of filing: 28.03.2024
(51) Int. Cl.: G01R 15/04

(54) **RESISTIVE VOLTAGE DIVIDER**
RESISTIVER SPANNUNGSTEILER
DIVISEUR DE TENSION RÉSISTIF

(43) Date of publication of application: 01.10.2025
(73) Proprietor: LEM International SA, 1217 Meyrin (CH)
(72) Inventor: BUHLMANN, Félix, 1010 LAUSANNE (CH); SCHLÄFLI, Dominik, 1260 NYON (CH)
(74) Representative: reuteler & cie SA

(56) References cited:
- EP-B1- 2 577 328
- US-A1- 2005 077 888
- US-A1- 2007 126 416

## Description

The present invention relates to a resistor based voltage divider.

Voltage dividers have a wide range of users from adjusting the level of a signal to biasing acting devices, and are disclosed for instance in US2005/0077888A1, US7,079,004, US7,268,663, US6,344,952, US9,645,174, and US8,878,330.

Applications with high voltage, high frequency, yet every increasing miniaturization increase the challenge of providing voltage dividers that have the required performance such as high impedance to limit power consumption, and accurate linear signal output.

It is known to provide high impedance voltage dividers in the form of a thin conductive track on a planar substrate, the thin conductive track having a meandering form, the length of which can be adjusted to define the resistance of the conductive track. Such thin planar voltage dividers, especially for high impedance and high frequency applications, are affected by external electrical fields, in particular high frequency alternating current fields that affect the output voltage of the voltage divider. Voltage dividers used in sensing or control applications, among others, require accurate linear output signals and it is therefore desirable to reduce the adverse effects of external electrical fields.

It is known to provide resistive voltage dividers with a shielding layer. The shielding layer however introduces a capacitive coupling between thin film conductive tracks of the voltage divider to the shielding plate that also adversely affects the output measurement.

In view of the foregoing, it is an object of this invention to provide a thin film resistive voltage divider that provides an accurate voltage output even the presence of external electrical fields.

It is advantageous to provide a resistive voltage divider that is compact.

It is advantageous to provide a resistive voltage divider that can be easily adjusted for different voltage levels.

It is advantageous to provide a resistive voltage divider that is economical to produce.

Objects of this invention have been achieved by providing a system according to claim 1. Dependent claims set forth various advantageous features of embodiments of the invention.

Disclosed herein is a resistive voltage divider comprising a resistive conductor track (3) formed on a substrate and shield plates overlaying at least a portion of the resistive conductor track and separated therefrom by an insulating layer. The resistive conductor track comprises a first resistor section extending between a first end terminal and one of one or two output terminals, and a second or a third resistor section extending between a second end terminal and one of said one or two output terminals, the first end terminal for connection to a first voltage (***Vin*+**), the second end terminal for connection to a second voltage (***Vin-***), the one or two output terminals for connection to one or two output voltages (***Vout+, Vout-***).

The shield plates comprise a first shield plate at least partially overlaying the first resistor section, and a second shield plate at least partially overlaying the second or the third resistor section.

The first shield plate is electrically connected via a low impedance conductor to the first resistor section and the second shield plate is electrically connected via a low impedance element to the first resistor section and the second shield plate electrically connected via a low impedance element to the second or third resistor section, the low impedance element being either a conductor or an active circuit

In an advantageous embodiment, the first shield plate is electrically connected via a low impedance conductor to the first end terminal, and the second shield plate is electrically connected via a low impedance conductor to the second end terminal.

In an advantageous embodiment, the first shield plate overlies more than 60%, preferably more than 70%, of the first resistor section .

In an advantageous embodiment, the second shield plate overlies more than 60%, preferably more than 70%, of the second or third resistor section.

In an advantageous embodiment, the first shield plate overlies more than 80%, preferably more than 90%, of the first resistor section.

In an advantageous embodiment, the second shield plate overlies more than 80%, preferably more than 90%, of the second or third resistor section.

In an advantageous embodiment, the resistive voltage divider is a differential voltage divider, wherein the first resistor section extends between the first end terminal and a first of said two output terminals, and the third resistor section extends between the second end terminal and a second of said two output terminals, and the second resistor section extends between the first and second output terminals.

In an advantageous embodiment, the shield plates further comprise a centre shield plate overlaying a portion of the first shield plate proximate the output terminals and a portion of the second shield plate proximate the output terminals, the centre shield plate insulatingly separated from the first and second shield plates.

In an advantageous embodiment, the centre shield plate overlies at least 10%, preferably at least 15% of each of the first and second shield plates, but less than 40% of each of the first and second shield plates.

In an advantageous embodiment, ends of the centre shield plate have a tapered shape.

In an advantageous embodiment, the resistive voltage divider is a non-differential voltage divider, wherein the first resistor section extends between the first end terminal and a single said output terminal, and the second resistor section extends between the second end terminal and the single output terminal.

In an advantageous embodiment, the resistive conductor track has a resistance value over 100 kΩ.

In an advantageous embodiment, the first and second shield plates are spaced apart from the resistive conductor track by a distance in a range between 1 % and 500 % of the track width, preferably in a range of 5 % to 200 %, more preferably in a range from 10 % to 100 %.

In an advantageous embodiment, the resistive conductor track is formed as a thin planar conductive track in a meandering path.

In an advantageous embodiment, resistive conductor track, and shield plates are formed in a printed circuit board, or in an LTCC substrate.

Further objects and advantageous features of the invention will be apparent from the claims, from the detailed description, and annexed drawings, in which:
Figure 1a is a schematic perspective view of a thin planar voltage divider that does not comprise the features of the invention.
Figure 1b is a schematic representation showing the coupling of external electrical fields with the voltage divider according to figure 1a;
Figure 2a is a schematic perspective view of a voltage divider similar to figure 1a but provided with shielding layers not within the scope of the present invention;
Figure 2b is a schematic diagram illustrating the voltage divider of figure 2a with the capacitive coupling between the shielding layer and the resistor of the voltage divider;
Figure 3a is a schematic perspective view of a resistive voltage divider according to an embodiment of the invention, this embodiment having a differential voltage output;
Figure 3b is a schematic illustration of the capacitive coupling between shielding plates of the voltage divider of figure 3a and the resistor tracks;
Figure 4a is a schematic perspective view of a resistive voltage divider according to another embodiment of the invention, this embodiment also having a differential voltage output;
Figure 4b is a schematic circuit diagram illustrating the capacitive coupling between the shielding plates and the resistive conductor track of the embodiment of figure 4a;
Figure 4c is another schematic perspective view of a resistive voltage divider of the embodiment of figure 4a showing conductive interconnection vias between layers connecting the shielding layers to the resistor;
Figure 5a is a schematic perspective view of a resistive voltage divider according to another embodiment of the invention, this embodiment having a single (or non-differential) voltage output;
Figure 5b is a schematic circuit diagram illustrating the capacitive coupling between the shielding plates and the resistive conductor track of the embodiment of figure 5a;
Figure 5c is another schematic perspective view of a resistive voltage divider of the embodiment of figure 5a showing conductive interconnection vias between layers connecting the shielding layers to the resistor;
Figure 6 is a top plan view of a resistive meandering conductor track of a differential output voltage divider according to an embodiment of the invention;
Figure 7 is a top plan view of a resistive meandering conductor track of a single (non-differential) output voltage divider according to an embodiment of the invention;
Figure 8a is a top view of another shielding layer arrangement of a voltage divider according to an embodiment of the invention;
Figure 8b and 8c are top views of alternative shielding layer arrangements of single ended voltage dividers according to other embodiments of the invention;
Figures 9a to 9f are different plots of the performance of the voltage dividers illustrated in figures 1a, 2a and 3a respectively, whereby

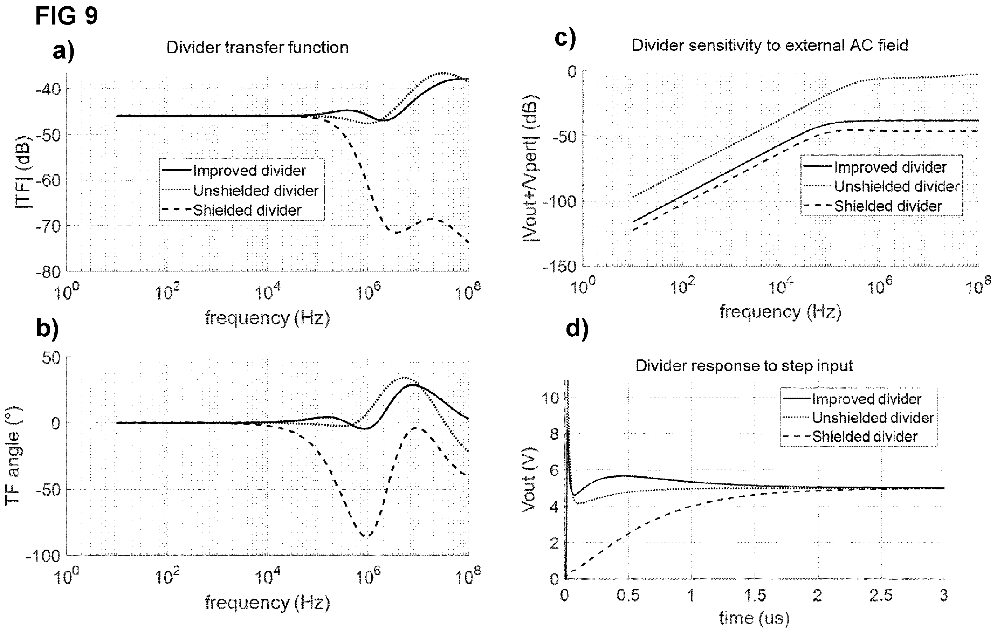

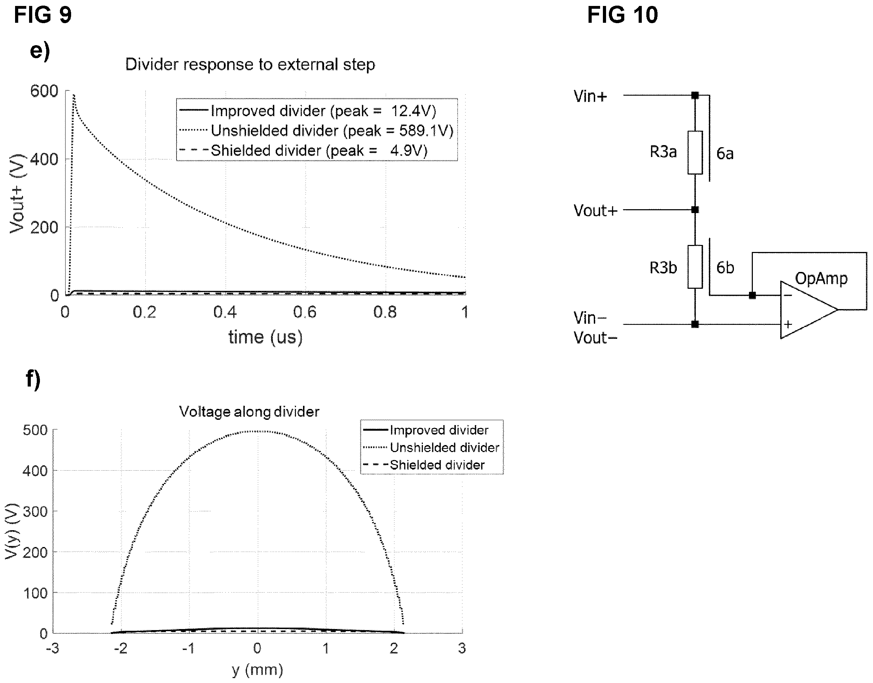

   - figure 9a is a magnitude plot of the divider transfer function in decibels as a function of the frequency of an external parasitic electrical field;
   - figure 9b is a phase plot showing the divider transfer function in degrees with respect to a frequency of the external electrical field;
   - figure 9c is a magnitude plot of divider sensitivity to an external alternating electrical field showing the module of the output voltage divided by the perturbation (parasitic) voltage of the external parasitic field as a function the frequency of the alternating field;
   - figure 9d is a plot of the voltage divider response to a stepped voltage input in the voltage divider, showing the voltage output as a function of time in microseconds;
   - figure 9e is a plot of the voltage divider response to an external electrical field step change, showing the output voltage over time in microseconds;
   - figure 8f is a plot showing a voltage along the Y axis of the resistor subject to an external electrical field.

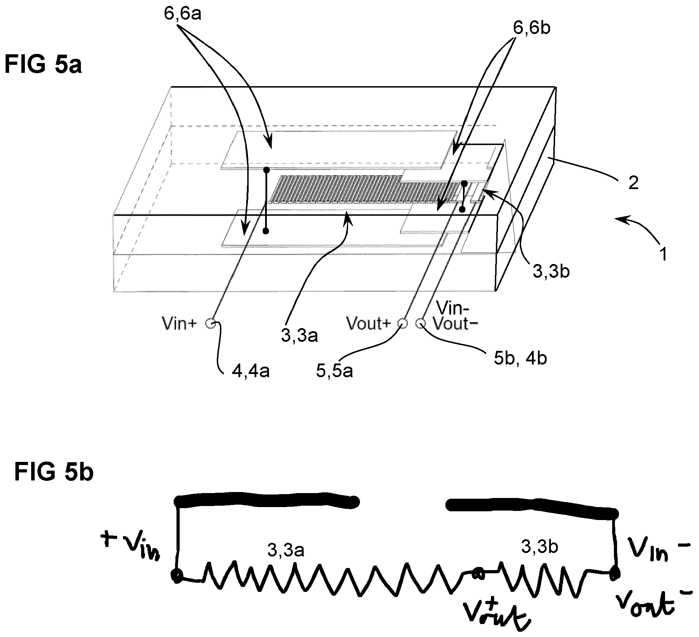

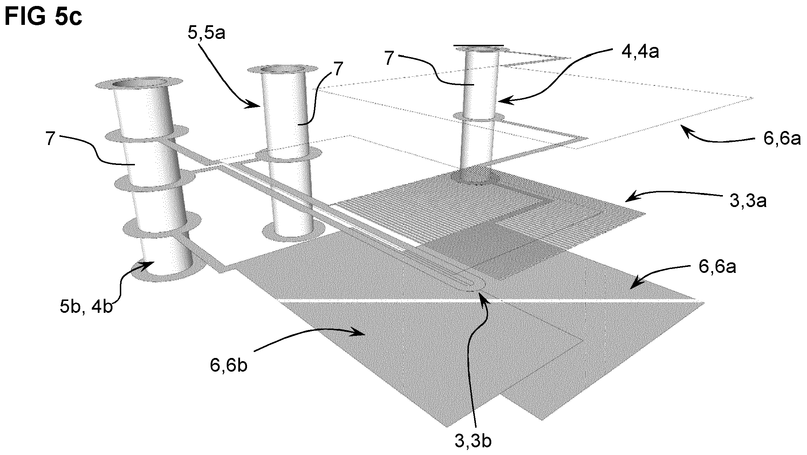

Figure 10 is a circuit diagram showing an actively driven shield for an alternative embodiment of a single ended divider according to fig. 5, whereby such a configuration permits to drive a shield with a low impedance also from an intermediate potential between **Vin+** and **Vin-.**

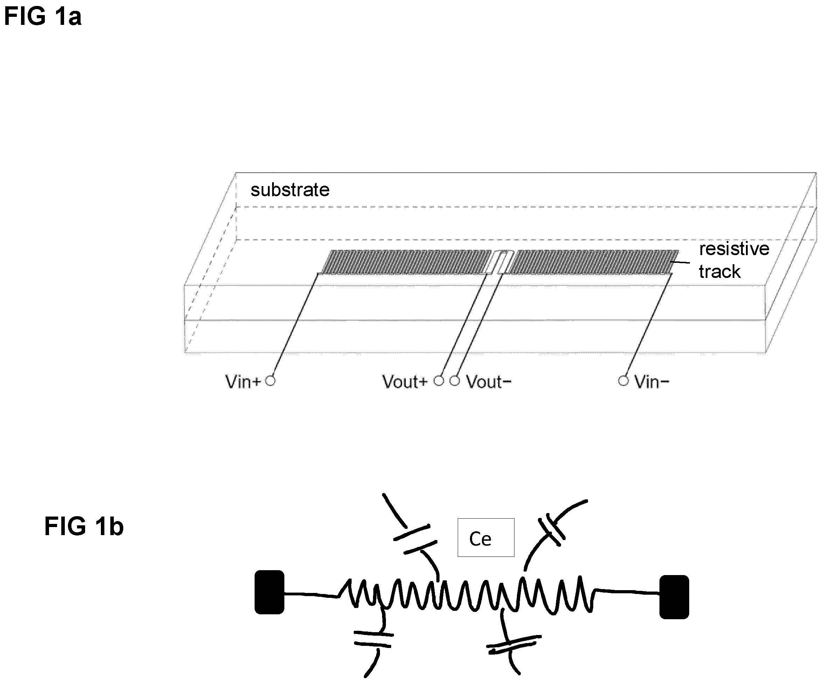

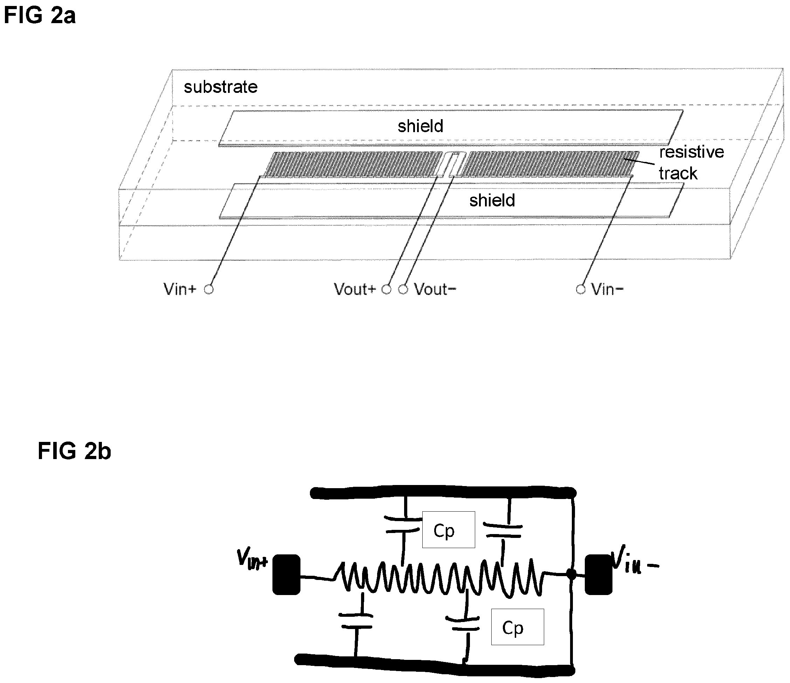

Referring to the figures, starting with figures 1a to 2b, a thin film resistive voltage divider without any shielding is subject to coupling to external electrical alternating current fields that generate a parasitic capacitance **Ce.** Adding a shield over the thin film conductive track of the voltage divider protects against external electrical fields, however adds new parasitic capacitances **Cp** and modifies the performance of the voltage divider at high frequencies. The frequency bandwidth of a voltage divider can be considerably reduced due to parasitic capacitances between the resistive conductor track and shield layer. These parasitic capacitances **Cp** increase when the shield is closer to the resistive track, which is a problem for very compact designs.

The invention solves this problem by providing shielding for each section of the voltage divider, connected to the input voltages of each of the voltage divider sections. Parasitic capacitances between the resistive conductor track of each voltage divider section to the respective shielding layer is reduced in view of the partial matchings of the voltage, in both amplitude and frequency, of the shielding layers to the overlapping resistive conductor track. This is because the input voltage of each voltage divider section is connected to the corresponding shielding layer such that the voltage of at least an initial input portion of the resistive conductor track matches the overlapping shield and thus reduces capacitive coupling.

A resistive voltage divider 1 according to embodiments of the invention comprises a substrate 2, a resistive conductor track 3 formed in a layer of the substrate 2, the resistive conductor track 3 comprising a thin conductor track with a meandering path, *per se* known in the art. The resistive conductor track comprises a first resistor section 3a and at least a second resistor section 3b. In the embodiments with a differential voltage output, the resistive conductor track comprises a third resistor section 3c.

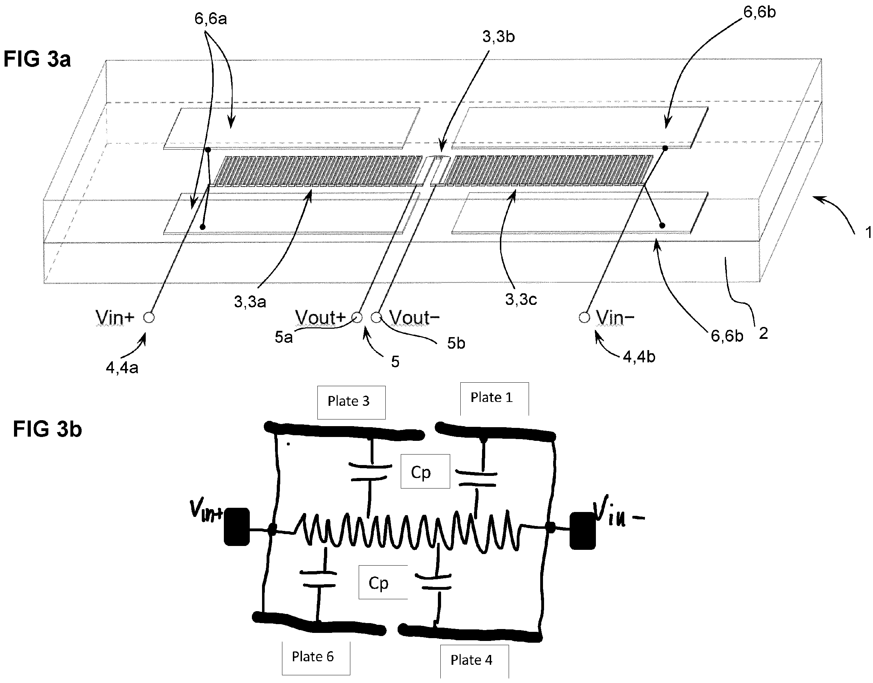

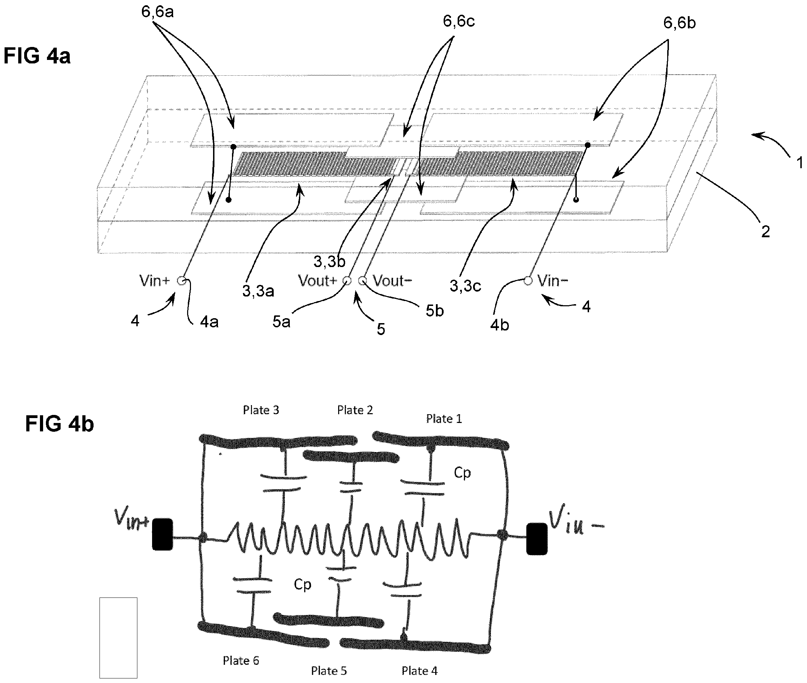

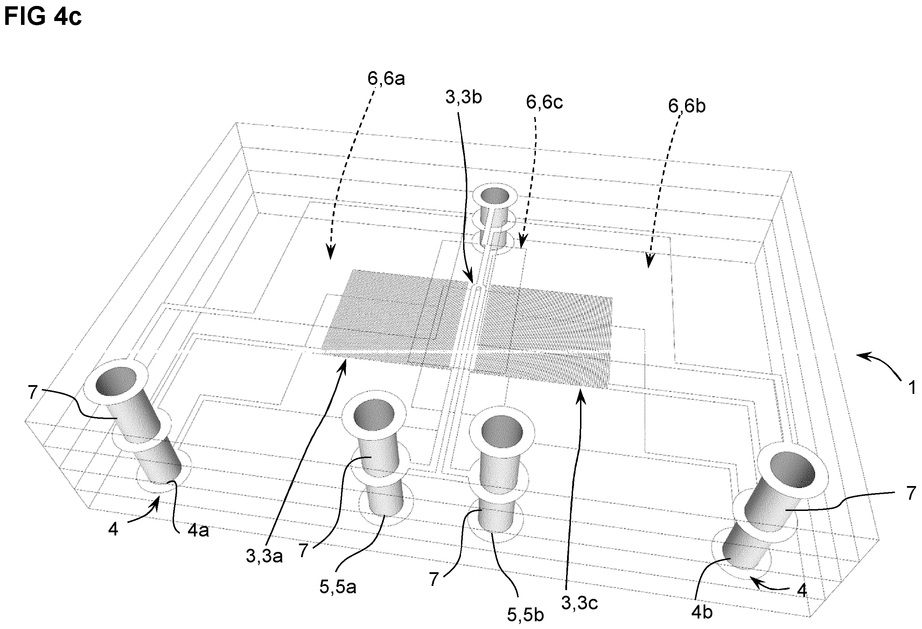

In the embodiments with a differential voltage output (figures 3a-4c and 6), the first resistor section 3a comprises a first end terminal 4a for connection to an input voltage **Vin+** and an output terminal 5a, being a first output terminal, and the third resistor section 3c comprises a second end terminal 4b connected to an input voltage **Vin-** and at the other end an output terminal 5b, being a second output terminal. The output terminals 5a, 5b of the first and second resistor sections are connected together via the second resistor section 3b. The output terminals are connected to output voltage connection **Vout+, Vout-** that form a differential voltage output signal.

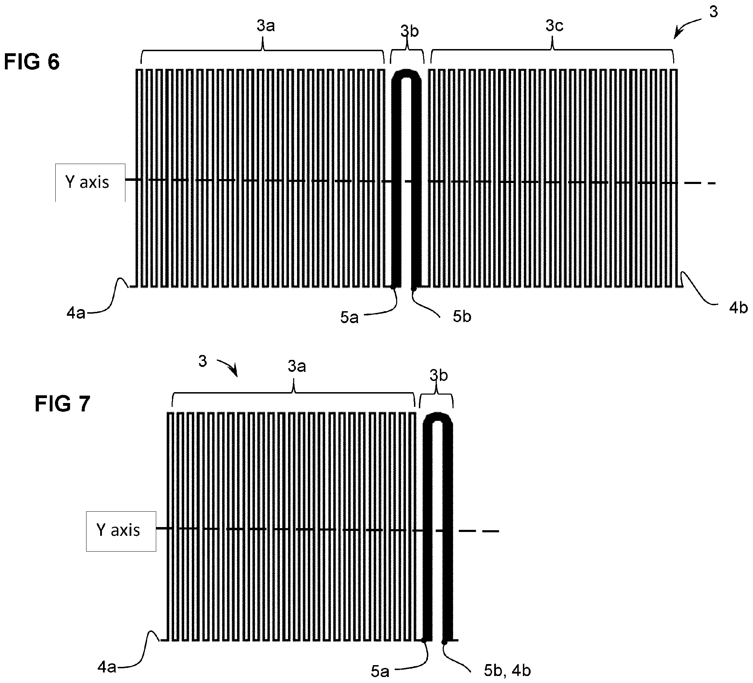

In the embodiments with a single ended voltage output (figures 5a-5c and 7), the first resistor section 3a comprises a first end terminal 4a for connection to an input voltage **Vin+** and an output terminal 5a, being the single output terminal, and the second resistor section 3b comprises a second end terminal 4b connected at the other end to said single output terminal 5a.

In order to have a high voltage division, for instance of a division factor of 10⁻² to 10⁻³, to go from an input voltage of for instance of 1000V to an output voltage of 3V, the second resistor section may have a much lower resistance than the first and third resistor sections. In the illustrated embodiments, this can be seen by comparing the thin long meandering first and third resistor sections 3a, 3c with the shorter, thicker second resistor section 3b.

The first resistor section 3a may have a different resistance value to the second resistor section 3b depending on the required division between the input and output voltages of the resistive voltage divider, as *per se* well known in the art.

The resistances of each resistor section 3a, 3b, 3c may be adjusted by adjusting the length and/or thickness/width of the resistive conductor track of the corresponding section. This for instance may be performed easily by connection of the end terminal at the desired position along the *Y* axis of the meandering path. However, other techniques for adjusting the resistance of the meandering connection path may be implemented, for instance by varying the conductor track cross-section, or the material of the conductor track.

In the embodiments with a single ended voltage output (figures 5a-5c and 7), the resistive voltage divider according to the invention further comprises shield plates 6, including at least a first shield plate 6a and a second shield plate 6b, the first shield plate 6a overlying at least partially the first resistor section 3a and the second shield plate 6b overlying at least partially the second resistor section 3b. The shield plates are separated from the resistive conductor track by an insulating layer.

In the embodiments with a differential voltage output (figures 3a-4c and 6), the shield plates 6, include at least a first shield plate 6a and a second shield plate 6b, the first shield plate 6a overlying at least partially the first resistor section 3a and the second shield plate 6b overlying at least partially the third resistor section 3b. The shield plates are separated from the resistive conductor track by an insulating layer.

The first shield plate 6a is electrically connected by a low impedance conductive path to the first resistor section 3a, at or proximate the first end terminal 4a, such that the voltage of the first shield plate 6a is at the voltage of the first end terminal 4a. In a variant, the first shield plate 6a may be electrically connected by a low impedance conductive path to the first resistor section 3a, at a position between the end terminal and the output terminal, such that the voltage of the first shield plate 6a is at the voltage situated between the voltage of of the first end terminal 4a and of the output terminal 5a.

In the embodiments with a differential voltage output, the second shield plate 6b is similarly electrically connected by a low impedance conductive path to the third resistor section 3c, at or proximate the second end terminal 4b, such that the voltage of the second shield plate 6b is at the voltage of the second end terminal 4b. In a variant, the second shield plate 6b may be electrically connected by a low impedance conductive path to the third resistor section 3c, at a position between the second end terminal 4b and the second output terminal 5b, such that the voltage of the second shield plate 6b is at the voltage situated between the voltage of the second end terminal 4b and of the second output terminal 5b.

Capacitive coupling between the first shield plate 6a and first resistor section 3a and capacitive coupling between the second shield plate 6b and third resistor section 3c are thus reduced.

The first shield plate 6a may only partially overlay the first resistor section 3a and likewise the second shield plate 6b may only partially overlay the third resistor section 3c, whereby the overlay should be more than 60%, preferably more than 70%, yet more preferably more than 80% and optimally more than 90%.

In an embodiment with a differential voltage output, the resistive voltage divider may further comprise a centre shield plate 6c that extends over the second resistor section 3b and partially over the first resistor section 3a and third resistor section 3c at their respective output terminal ends 5a, 5b, the centre shield plates 6c partially overlapping the first shield plates 6a and second shield plates 6b. The centre shield plate 6c thus capacitively couples to the first and second shield plates 6a, 6b such that the voltages at the centre portions of the shield plates are better matched to the voltage of the first and third resistor sections 3a, 3b proximate the voltage output terminals 5a, 5b of the voltage divider.

The centre shield plate overlies at least 10%, preferably at least 15% of each of the first and second shield plates, but less than 40% of each of the first and second shield plates,
In the embodiments with a single ended voltage output, the shield plates 6, include a first shield plate 6a and a second shield plate 6b, the first shield plate 6a overlying at least partially the first resistor section 3a and the second shield plate 6b overlying at least partially the second resistor section 3b. The shield plates are separated from the resistive conductor track by an insulating layer.

The first shield plate 6a is electrically connected by a low impedance conductive path to the first resistor section 3a, at or proximate the first end terminal 4a, such that the voltage of the first shield plate 6a is at the voltage of the first end terminal 4a. In a variant, the first shield plate 6a may be electrically connected by a low impedance conductive path to the first resistor section 3a, at a position between the end terminal and the output terminal, such that the voltage of the first shield plate 6a is at the voltage situated between the voltage of the first end terminal 4a and of the output terminal 5a.

In the embodiments with a differential voltage output, the second shield plate 6b is similarly electrically connected by a low impedance conductive path to the second resistor section 3b, at or proximate the second end terminal 4b, such that the voltage of the second shield plate 6b is at the voltage of the second end terminal 4b. In a variant, the second shield plate 6b may be electrically connected by a low impedance conductive path to the second resistor section 3b, at a position between the second end terminal 4b and the single output terminal 5a, such that the voltage of the second shield plate 6b is at the voltage situated between the voltage of the second end terminal 4b and of the single output terminal 5a.

Capacitive coupling between the first shield plate 6a and first resistor section 3a and capacitive coupling between the second shield plate 6b and second resistor section 3b are thus reduced.

Instead of connecting shield plates directly to the resistive conductor track or its input or output terminals, shield plates can also be driven by an active circuit containing an operational amplifier OpAmp or a an equivalent impedance conversion circuit as shown in figure 10.

The first shield plate 6a may only partially overlay the first resistor section 3a and likewise the second shield plate 6b may only partially overlay the second resistor section 3b, whereby the overlay should be more than 60%, preferably more than 70%, yet more preferably more than 80% and optimally more than 90%.

The shield plates 6 may be arranged only on one side of the resistive conductor track 3, or may be arranged on both sides of the resistive conductor track 3, depending on the origin of external electrical fields. Having shielding plates on both opposing sides improves global shielding and protection against external fields, however if the external electrical fields are generated only on one side of the voltage divider in the intended implementation, the other side may be left unshielded.

The conductive interconnection between the shield plates and the resistor sections may be in the form of conductive vias 7 extending through the insulating layers.

The resistive conductor track of the voltage divider as well as the terminals and the shielding layers and conductive interconnection between the shield layers and the conductor track may be made by *per se* standard multi-layer technologies such as printed circuit board technologies, low temperature co-fired ceramic (LTCC) technologies and similar. Resistive conductor tracks of the voltage divider may be made on a separate substrate from the shield plates, the components being assembled together.

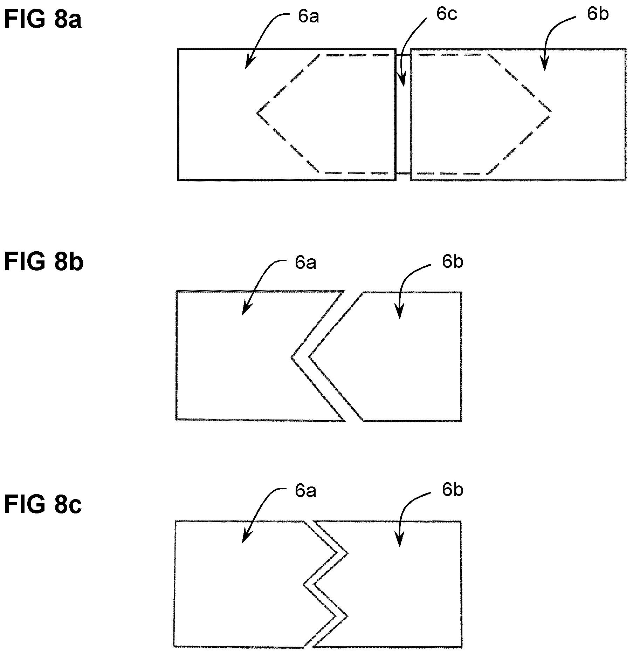

In an embodiment, for instance as illustrated in figure 8a, the centre shield plate 6c may have a tapered end shapes such that the capacitive coupling between the centre shield plate and the first shield plate and/or second shield plate reduces as the shield plate extends away from the centre portion of the voltage divider. Although the illustrated end shape is shown as a straight line chamfer, in variants it may be curved, parabolic or have various shapes configured to progressively reduce the capacitive coupling between the centre shield plate and the first and second shield plates as the position moves further way from the centre.

In an embodiment, for instance as illustrated in figure 8b or 8c, shield plates 6a and 6b are not overlapping as shown in figure 5a leading to a reduced capacitive coupling between these shield plates. For a gradual potential change of the electrical potential along the conductive track resistor, the shield plates can have single or multiple tapered end shapes as shown.

Embodiments of the invention are particularly advantageous for resistor values having 100 kΩ or higher, and for operation at frequencies above 10 Hz. Voltage dividers according to embodiments of the invention may for instance have a Y-axis length that may range from 1 mm to 10 cm.

The distance between the shield plates and the voltage resistor conductor track is preferably very small but large enough to guarantee a good insulation, between 1 % and 500 % of the track width, preferably in a range of 5 % to 200 %, more preferably in a range from 10 % to 100 %.. The close spacing between the shield plate and the resistive conductor track of the voltage divider advantageously enhances the protection from external fields without the disadvantage of the capacitive coupling between the shield plates and the resistive conductor track affecting performance in view of the interconnection between the shield plates and respective end terminals of the voltage divider.

The performance of voltage dividers illustrated in figures 1a to 3b are illustrated in figures 9a to 9e. In these simulations, the following parameters have been implemented.
▪ 3 model setups : unshielded, shielded, improved
▪ 2 voltage excitation sources : voltage on divider inputs (Vin), voltage on perturbation plate (Vpert).
▪ 2 voltage excitation mode : time domain mode (time) or frequency domain mode (AC) Step excitation is a 1000V voltage step with 10ns rise time. Sinusoidal excitation is a 1000V sine voltage from 10 Hz - 100 MHz

For all models
▪ Resistors: divider total surface 2 mm x 4.3 mm
▪ R1 = 10 MΩ (total) serpentine 20 µm line width/spacing, 1 kΩ/□ resistivity, 50 meanders
▪ R2 = 50 kΩ serpentine 80 µm line width/spacing, 1 kΩ/□ resistivity, 1 meanders
▪ Substrates: 10 mm x 7.2 mm x 0.427 mm each, εᵣ = 4.05
▪ Perturbation plate: 27 mm x 12.96 mm at z = 3.84 mm
▪ Shields (shielded model): 2.8 mm x 5.8 mm at z = +/- 0.427 mm
▪ Plates (improved model): 2.8 mm x 2.9 mm at z = +/- 0.427 mm (plates 1,3,4,6), 2.8 mm x 1.4 mm (plates 2,5) z = +/- 0.277 mm

### List of references used

**Voltage divider 1**
   substrate 2
   resistive conductor track 3
      meanders
      first resistor section 3a
      second resistor section 3b
      third resistor section 3c
      end terminals 4, 4a, 4b
         first end terminal 4a
         second end terminal 4b
      output terminal(s) 5
         first output terminal 5a
         second output terminal 5b
      conductive vias 7
   shield plates 6
      first shield plate(s) 6a
      second shield plate(s) 6b
      centre shield plate(s) 6c

## Claims

1. A resistive voltage divider comprising a resistive conductor track (3) formed on a substrate (2) and shield plates (6) overlaying at least a portion of the resistive conductor track (3) and separated therefrom by an insulating layer, the resistive conductor track (3) comprising a first resistor section (3a) extending between a first end terminal (4a) and one of one or two output terminals (5a, 5b) and a second or a third resistor section (3b, 3c) extending between a second end terminal (4b) and one of said one or two output terminals (5a, 5b), the first end terminal (4a) for connection to a first voltage (***Vin*+**), the second end terminal (4b) for connection to a second voltage (***Vin*-**), the one or two output terminals (5a, 5b) for connection to one or two output voltages (***Vout*+, *Vout***-) respectively, **characterized in that** the shield plates comprise a first shield plate (6a) at least partially overlaying the first resistor section (3a), and a second shield plate (6b) at least partially overlaying the second or the third resistor section (3b, 3c), the first shield plate (6a) electrically connected via a low impedance element to the first resistor section and the second shield plate electrically connected via a low impedance element to the second or third resistor section, the low impedance element being either a conductor or an active circuit.

2. The resistive voltage divider according to the preceding claim wherein the first shield plate (6a) is electrically connected via a low impedance element to the first end terminal (4a), and the second shield plate (6b) is electrically connected via a low impedance element to the second end terminal (4b).

3. The resistive voltage divider according to any preceding claim wherein the first shield plate (6a) overlies more than 60%, preferably more than 70%, of the first resistor section (3a).

4. The resistive voltage divider according to any preceding claim wherein the second shield plate (6b) overlies more than 60%, preferably more than 70%, of the second or third resistor section (3b, 3c).

5. The resistive voltage divider according to any preceding claim wherein the first shield plate (6a) overlies more than 80% , preferably more than 90%, of the first resistor section (3a).

6. The resistive voltage divider according to any preceding claim wherein the second shield plate (6b) overlies more than 80%, preferably more than 90%, of the second or third resistor section (3b, 3c).

7. The resistive voltage divider according to any preceding claim configured as a differential voltage divider, wherein the first resistor section (3a) extends between the first end terminal (4a) and a first of said two output terminals (5a, 5b), and the third resistor section (3c) extends between the second end terminal (4b) and a second of said two output terminals (5a, 5b), and the second resistor section extends between the first and second output terminals.

8. The resistive voltage divider according to the preceding claim wherein the shield plates further comprise a centre shield plate (6c) overlaying a portion of the first shield plate (6a) proximate the output terminals and a portion of the second shield plate (6b) proximate the output terminals, the centre shield plate (6) insulatingly separated from the first and second shield plates (6a, 6b).

9. The resistive voltage divider according to the preceding claim wherein the centre shield plate overlies at least 10%, preferably at least 15% of each of the first and second shield plates, but less than 40% of each of the first and second shield plates.

10. The resistive voltage divider according to the preceding claim wherein ends of the centre shield plate have a tapered shape.

11. The resistive voltage divider according to any preceding claim 1-6 configured as a non-differential voltage divider, wherein the first resistor section (3a) extends between the first end terminal (4a) and a single said output terminal (5a), and the second resistor section extends between the second end terminal (4b) and the single output terminal.

12. The resistive voltage divider according to any preceding claim wherein the resistive conductor track has a resistance value over 100 kΩ.

13. The resistive voltage divider according to any preceding claim wherein the first and second shield plates are spaced apart from the resistive conductor track by a distance in a range between 1 % and 500 % of the track width, preferably in a range of 5 % to 200 %, more preferably in a range from 10 % to 100 %.

14. The resistive voltage divider according to any preceding claim wherein the resistive conductor track is formed as a thin planar conductive track in a meandering path.

15. The resistive voltage divider according to any preceding claim wherein the resistive conductor track, and shield plates are formed in a printed circuit board, or in an LTCC substrate.

## Patentansprüche

1. Resistiver Spannungsteiler mit einer resistiven Leiterbahn (3), die auf einem Substrat (2) ausgebildet ist, und Abschirmplatten (6), die mindestens einen Teil der resistiven Leiterbahn (3) überdecken und von dieser durch eine Isolierschicht getrennt sind, wobei die resistive Leiterbahn (3) einen ersten Widerstandsabschnitt (3a), der sich zwischen einem ersten Endanschluss (4a) und einem von einem oder zwei Ausgangsanschlüssen (5a, 5b) erstreckt, und einen zweiten oder dritten Widerstandsabschnitt (3b, 3c), der sich zwischen einem zweiten Endanschluss (4b) und einem des einen oder der zwei Ausgangsanschlüsse (5a, 5b) erstreckt, umfasst, wobei der erste Endanschluss (4a) für die Verbindung mit einer ersten Spannung (Vin+) vorgesehen ist, der zweite Endanschluss (4b) für die Verbindung mit einer zweiten Spannung (Vin-) vorgesehen ist und der eine oder die zwei Ausgangsanschlüsse (5a, 5b) für die Verbindung mit einer bzw. zwei Ausgangsspannungen (Vout+, Vout-) vorgesehen sind, **dadurch gekennzeichnet, dass** die Abschirmplatten eine erste Abschirmplatte (6a), die zumindest teilweise den ersten Widerstandsabschnitt (3a) überdeckt, und eine zweite Abschirmplatte (6b), die zumindest teilweise den zweiten oder den dritten Widerstandsabschnitt (3b, 3c) überdeckt, umfasst, die erste Abschirmplatte (6a) über ein niedrigohmiges Element elektrisch mit dem ersten Widerstandsabschnitt verbunden ist und die zweite Abschirmplatte über ein niederohmiges Element elektrisch mit dem zweiten oder dem dritten Widerstandsabschnitt verbunden ist, wobei das niederohmige Element entweder ein Leiter oder eine aktive Schaltung ist.

2. Resistiver Spannungsteiler nach dem vorstehenden Anspruch, wobei die erste Abschirmplatte (6a) über ein niederohmiges Element mit dem ersten Endanschluss (4a) elektrisch verbunden ist und die zweite Abschirmplatte (6b) über ein niederohmiges Element mit dem zweiten Endanschluss (4b) elektrisch verbunden ist.

3. Resistiver Spannungsteiler nach einem der vorstehenden Ansprüche, wobei die erste Abschirmplatte (6a) mehr als 60%, vorzugsweise mehr als 70%, des ersten Widerstandsabschnitts (3a) überdeckt.

4. Resistiver Spannungsteiler nach einem der vorstehenden Ansprüche, wobei die zweite Abschirmplatte (6b) mehr als 60%, vorzugsweise mehr als 70%, des zweiten oder des dritten Widerstandsabschnitts (3b, 3c) überdeckt.

5. Resistiver Spannungsteiler nach einem der vorstehenden Ansprüche, wobei die erste Abschirmplatte (6a) mehr als 80%, vorzugsweise mehr als 90%, des ersten Widerstandsabschnitts (3a) überdeckt.

6. Resistiver Spannungsteiler nach einem der vorstehenden Ansprüche, wobei die zweite Abschirmplatte (6b) mehr als 80%, vorzugsweise mehr als 90%, des zweiten oder des dritten Widerstandsabschnitts (3b, 3c) überdeckt.

7. Resistiver Spannungsteiler nach einem der vorstehenden Ansprüche, der als differentieller Spannungsteiler konfiguriert ist, wobei sich der erste Widerstandsabschnitt (3a) zwischen dem ersten Endanschluss (4a) und einem ersten der beiden Ausgangsanschlüsse (5a, 5b) erstreckt, und sich der dritte Widerstandsabschnitt (3c) zwischen dem zweiten Endanschluss (4b) und einem zweiten der beiden Ausgangsanschlüsse (5a, 5b) erstreckt, und sich der zweite Widerstandsabschnitt zwischen dem ersten und dem zweiten Ausgangsanschluss erstreckt.

8. Resistiver Spannungsteiler nach dem vorstehenden Anspruch, wobei die Abschirmplatten ferner eine mittlere Abschirmplatte (6c) umfassen, die einen Teil der ersten Abschirmplatte (6a) in der Nähe der Ausgangsanschlüsse und einen Teil der zweiten Abschirmplatte (6b) in der Nähe der Ausgangsanschlüsse überdeckt, wobei die mittlere Abschirmplatte (6) isolierend von der ersten und der zweiten Abschirmplatte (6a, 6b) getrennt ist.

9. Resistiver Spannungsteiler nach dem vorstehenden Anspruch, wobei die mittlere Abschirmplatte mindestens 10%, vorzugsweise mindestens 15% jeder der ersten und der zweiten Abschirmplatte, aber weniger als 40% jeder der ersten und der zweiten Abschirmplatte, überdeckt.

10. Resistiver Spannungsteiler nach dem vorstehenden Anspruch, wobei die Enden der mittleren Abschirmplatte eine konische Form aufweisen.

11. Resistiver Spannungsteiler nach einem der vorstehenden Ansprüche 1 bis 6, der als nicht-differentieller Spannungsteiler konfiguriert ist, wobei sich der erste Widerstandsabschnitt (3a) zwischen dem ersten Endanschluss (4a) und einem einzelnen Ausgangsanschluss (5a) erstreckt, und sich der zweite Widerstandsabschnitt zwischen dem zweiten Endanschluss (4b) und dem einzelnen Ausgangsanschluss erstreckt.

12. Resistiver Spannungsteiler nach einem der vorstehenden Ansprüche, wobei die resistive Leiterbahn einen Widerstandswert von über 100 kΩ aufweist.

13. Resistiver Spannungsteiler nach einem der vorstehenden Ansprüche, wobei die erste und die zweite Abschirmplatte von der resisitven Leiterbahn um einen Abstand in einem Bereich zwischen 1% und 500% der Bahnbreite, vorzugsweise in einem Bereich von 5% bis 200%, mehr bevorzugt in einem Bereich von 10% bis 100%, beabstandet sind.

14. Resistiver Spannungsteiler nach einem der vorstehenden Ansprüche, wobei die resistive Leiterbahn als dünne planare Leiterbahn in einem mäanderförmigen Pfad ausgebildet ist.

15. Resistiver Spannungsteiler nach einem der vorstehenden Ansprüche, wobei die resistive Leiterbahn und die Abschirmplatten in einer Leiterplatte oder in einem LTCC-Substrat ausgebildet sind.

## Revendications

1. Diviseur de tension résistif comprenant une piste conductrice résistive (3) formée sur un substrat (2) et des plaques de blindage (6) recouvrant au moins une partie de la piste conductrice résistive (3) et séparées de celle-ci par une couche isolante, la piste conductrice résistive (3) comprenant une première section de résistance (3a) s'étendant entre une première borne d'extrémité (4a) et l'une parmi une ou deux bornes de sortie (5a, 5b) et une deuxième ou une troisième section de résistance (3b, 3c) s'étendant entre une deuxième borne d'extrémité (4b) et l'une parmi lesdites une ou deux bornes de sortie (5a, 5b), la première borne d'extrémité (4a) étant pour une connexion à une première tension (Vin+), la deuxième borne d'extrémité (4b) étant pour une connexion à une deuxième tension (Vin-), les une ou deux bornes de sortie (5a, 5b) étant pour une connexion à une ou deux tensions de sortie (Vout+, Vout-) respectivement, **caractérisé en ce que** les plaques de blindage comprennent une première plaque de blindage (6a) recouvrant au moins partiellement la première section de résistance (3a), et une deuxième plaque de blindage (6b) recouvrant au moins partiellement la deuxième ou la troisième section de résistance (3b, 3c), la première plaque de blindage (6a) étant électriquement connectée par le biais d'un élément à faible impédance à la première section de résistance et la deuxième plaque de blindage étant électriquement connectée par le biais d'un élément à faible impédance à la deuxième ou à la troisième section de résistance, l'élément à faible impédance étant soit un conducteur, soit un circuit actif.

2. Diviseur de tension résistif selon la revendication précédente dans lequel la première plaque de blindage (6a) est électriquement connectée par le biais d'un élément à faible impédance à la première borne d'extrémité (4a), et la deuxième plaque de blindage (6b) est électriquement connectée par le biais d'un élément à faible impédance à la deuxième borne d'extrémité (4b).

3. Diviseur de tension résistif selon une quelconque revendication précédente dans lequel la première plaque de blindage (6a) recouvre plus de 60 %, de préférence plus de 70 %, de la première section de résistance (3a).

4. Diviseur de tension résistif selon une quelconque revendication précédente dans lequel la deuxième plaque de blindage (6b) recouvre plus de 60 %, de préférence plus de 70 %, de la deuxième ou de la troisième section de résistance (3b, 3c).

5. Diviseur de tension résistif selon une quelconque revendication précédente dans lequel la première plaque de blindage (6a) recouvre plus de 80 %, de préférence plus de 90 %, de la première section de résistance (3a).

6. Diviseur de tension résistif selon une quelconque revendication précédente dans lequel la deuxième plaque de blindage (6b) recouvre plus de 80 %, de préférence plus de 90 %, de la deuxième ou de la troisième section de résistance (3b, 3c).

7. Diviseur de tension résistif selon une quelconque revendication précédente configuré sous la forme d'un diviseur de tension différentielle, dans lequel la première section de résistance (3a) s'étend entre la première borne d'extrémité (4a) et une première borne parmi lesdites deux bornes de sortie (5a, 5b), et la troisième section de résistance (3c) s'étend entre la deuxième borne d'extrémité (4b) et une deuxième borne parmi lesdites deux bornes de sortie (5a, 5b) et la deuxième section de résistance s'étend entre les première et deuxième bornes de sortie.

8. Diviseur de tension résistif selon la revendication précédente dans lequel les plaques de blindage comprennent en outre une plaque de blindage centrale (6c) recouvrant une partie de la première plaque de blindage (6a) à proximité des bornes de sortie et une partie de la deuxième plaque de blindage (6b) à proximité des bornes de sortie, la plaque de blindage centrale (6) étant séparée de manière isolante des première et deuxième plaques de blindage (6a, 6b).

9. Diviseur de tension résistif selon la revendication précédente dans lequel la plaque de blindage centrale recouvre au moins 10 %, de préférence au moins 15 % de chacune des première et deuxième plaques de blindage, mais moins de 40 % de chacune des première et deuxième plaques de blindage.

10. Diviseur de tension résistif selon la revendication précédente dans lequel les extrémités de la plaque de blindage centrale possèdent une forme effilée.

11. Diviseur de tension résistif selon une quelconque revendication 1 à 6 précédente configuré sous la forme d'un diviseur de tension non différentielle, dans lequel la première section de résistance (3a) s'étend entre la première borne d'extrémité (4a) et une unique dite borne de sortie (5a), et la deuxième section de résistance s'étend entre la deuxième borne d'extrémité (4b) et l'unique borne de sortie.

12. Diviseur de tension résistif selon une quelconque revendication précédente dans lequel la piste conductrice résistive possède une valeur de résistance supérieure à 100 kΩ.

13. Diviseur de tension résistif selon une quelconque revendication précédente dans lequel les première et deuxième plaques de blindage sont espacées de la piste conductrice résistive d'une distance dans une plage entre 1 % et 500 % de la largeur de piste, de préférence dans une plage de 5 % à 200 %, plus préférentiellement dans une plage de 10 % à 100 %.

14. Diviseur de tension résistif selon une quelconque revendication précédente dans lequel la piste conductrice résistive se présente sous la forme d'une piste conductrice plane mince qui suit un chemin à méandres.

15. Diviseur de tension résistif selon une quelconque revendication précédente dans lequel la piste conductrice résistive et les plaques de blindage sont formées dans une carte de circuit imprimé ou dans un substrat LTCC.
